# EUROPEAN PATENT SPECIFICATION

(11) **EP 0 521 690 B1**
(45) Date of publication and mention of the grant of the patent: **03.09.1997**
(21) Application number: 92306011.5
(22) Date of filing: 30.06.1992
(51) Int. Cl.: H01L 29/788, H01L 21/82, H01L 27/115, G11C 16/04

(54) **Non-volatile memory and method of manufacturing the same**
Nichtflüchtiger Speicher und Verfahren zu seiner Herstellung
Mémoire rémanente et méthode pour sa fabrication

(30) Priority: 01.07.1991 JP 160692/91; 30.07.1991 JP 214533/91
(43) Date of publication of application: 07.01.1993
(73) Proprietor: SHARP KABUSHIKI KAISHA, Osaka (JP)
(72) Inventor: Yamauchi, Yoshimitsu, Tenri-shi, Nara-ken (JP)
(74) Representative: Brown, Kenneth Richard

(56) References cited:
- EP-A- 0 335 395
- EP-A- 0 386 631
- EP-A- 0 411 573

## Description

### BACKGROUND OF THE INVENTION

### 1. Field of the Invention

The present invention relates to a non-volatile memory device which can be integrated on a large scale and a method of manufacturing the same, and more specifically, it relates to a flash memory in which writing can be performed with a single power source of as low as 5 volts or less.

### 2. Description of the Prior Art

Since writing in a conventional flash memory is performed by hot electron injection from a drain side in a single transistor, it results in a low efficiency in writing, and approximately 1 mA of writing current is required for writing. Hence, a flash memory where a single power source of such low voltage as 5 volts or less is sufficient for writing cannot be achieved.

To overcome the above-mentioned disadvantages, there has been proposed a memory cell having a split type configuration. However, such a cell is 1.5 to 2 times as large as a conventional cell in area; thus, it is difficult to fabricate high density devices.

EP-A-0 335 395 discloses a non-volatile semiconductor memory device having a floating gate electrode and a control electrode mutually stacked, and a sidewall gate electrode extending along the sides of the stacked electrodes. Thus, all three electrodes extend in a common direction. A comparable disclosure is found in EP-A-0 411 573. An EPROM memory having buried bit lines is disclosed in EP-A-0 386 631.

### SUMMARY OF THE INVENTION

In one aspect, the present invention provides the non-volatile memory device defined by claim 1.

In another aspect, the present invention provides the method of forming a non-volatile memory device defined by claim 6.

The sub-claims are directed to embodiments of the invention.

### BRIEF DESCRIPTION OF THE DRAWINGS

Fig. 1 is a diagram for explaining a layout arrangement of a non-volatile memory of an embodiment according to the present invention;
Figs. 2(a) to 2(n) are diagrams showing a first embodiment of a manufacturing method according to the present invention;
Figs. 3(a) to 3(k) are diagrams showing a second embodiment of the manufacturing method according to the present invention;
Fig. 4 is a plan view showing an array of memory cells according to the present invention;
Fig. 5 is a diagram showing a process according to the manufacturing method, seen from the position orthogonal to the line B-B' of Fig. 4; and
Figs. 6 and 7 are an equivalent circuit diagram of the non-volatile memory according to the present invention and an equivalent circuit diagram of the non-volatile memory cell.

### DETAILED DESCRIPTION OF THE PREFERRED EMBODIMENTS

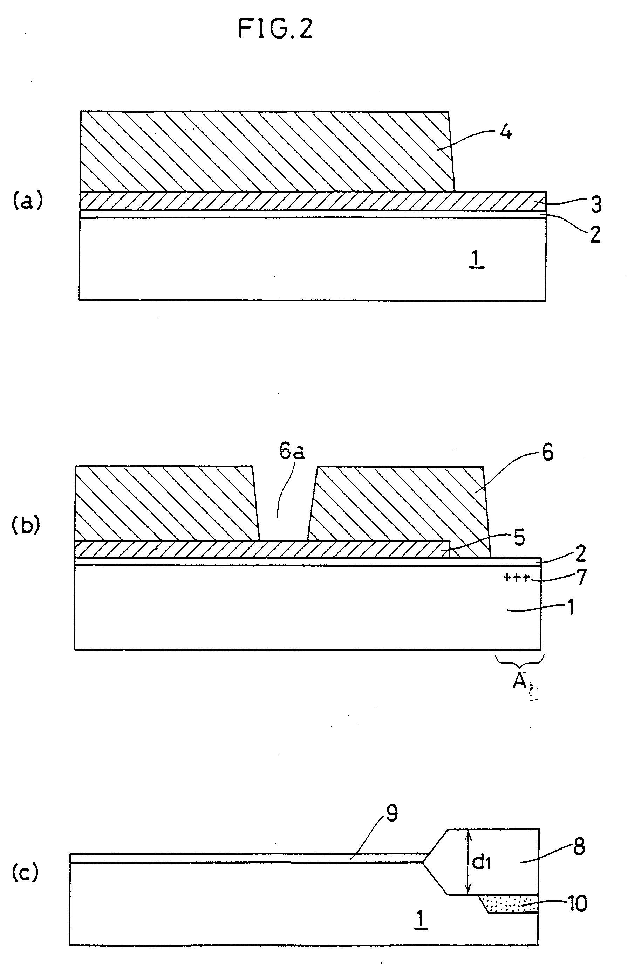

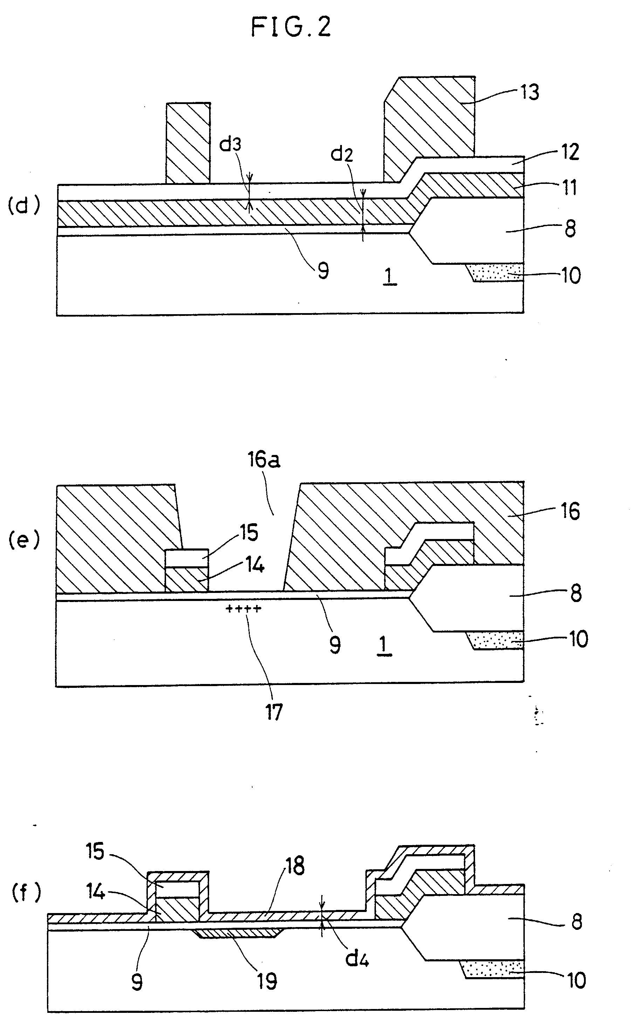

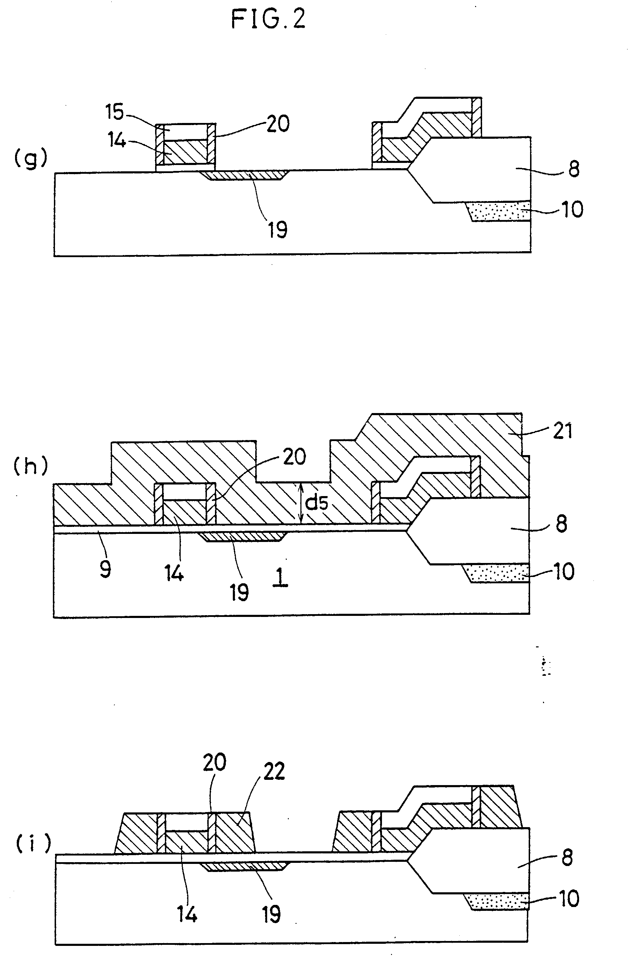

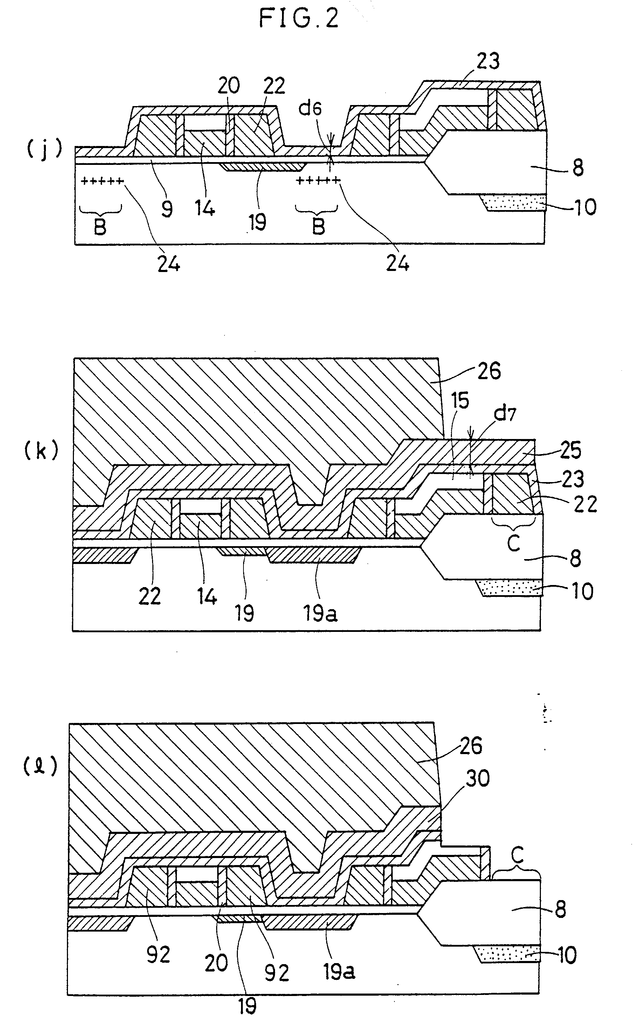

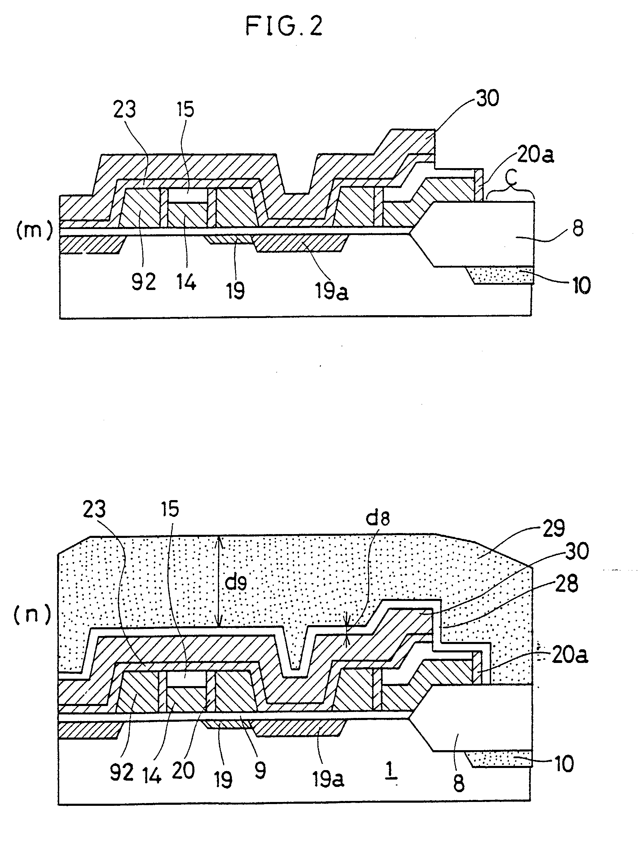

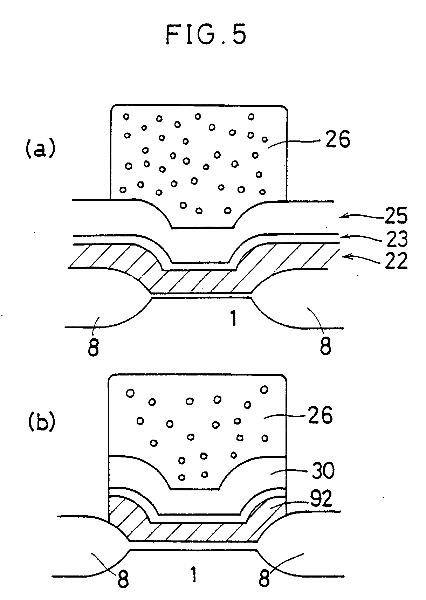

In the present invention, as shown in Figs. 5(a) and 5(b), simultaneous with etching to form a control gate (abbreviated as "CG" in this embodiment) 30, a side wall spacer 22 (see Fig. 2(k)) is etched so as to be contiguous to a side wall of an auxiliary gate (abbreviated as "AG" hereinafter) 14 [self-aligning], and also a floating gate (abbreviated as "FG") 92 is simultaneously formed. The FG 92 is formed in each of cells C1 and C2, isolated from each other. In other words, according to the present invention, the FG 92 can be formed in self-alignment with the AG 14 as well as the CG 30. Thus, a mask in forming the FG 92 is no longer required, and this makes a margin on a superimposition in masking avoidable.

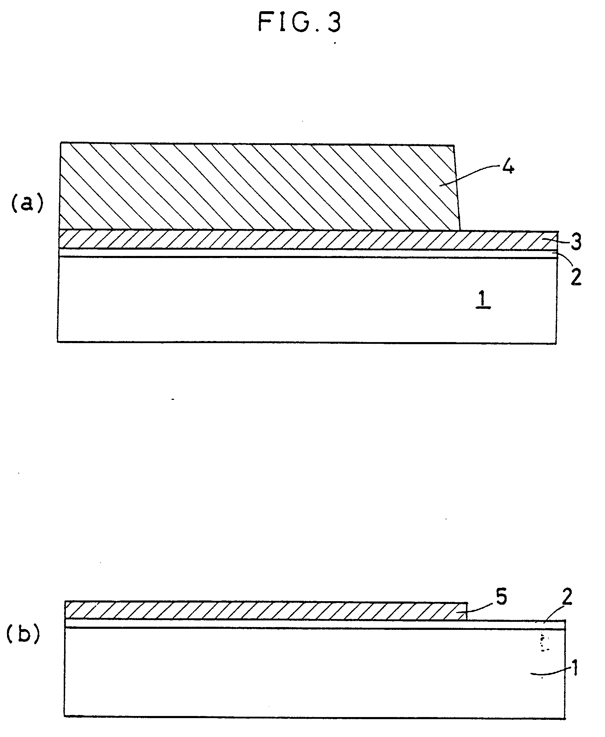

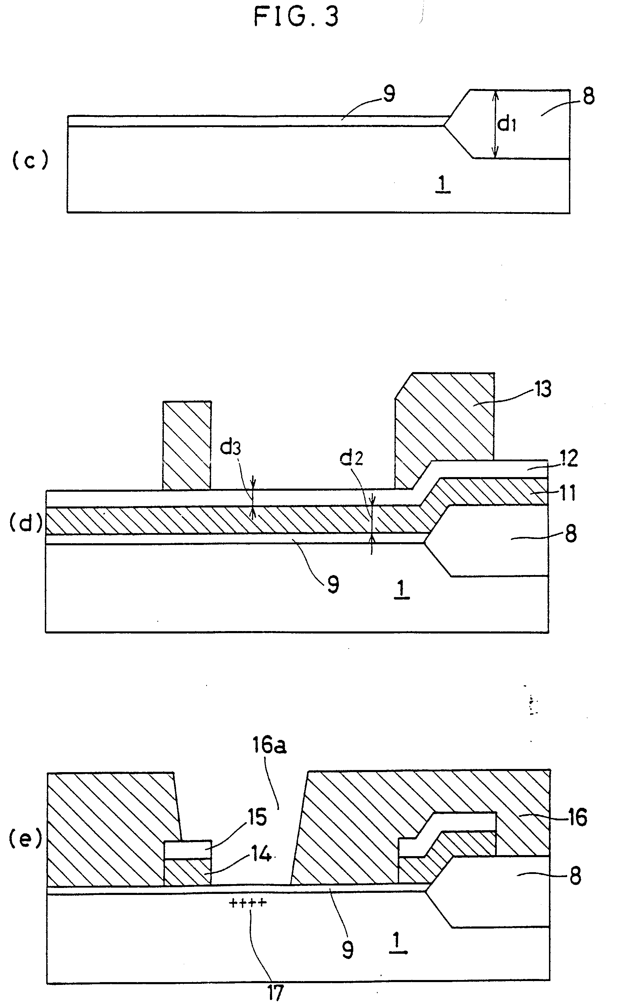

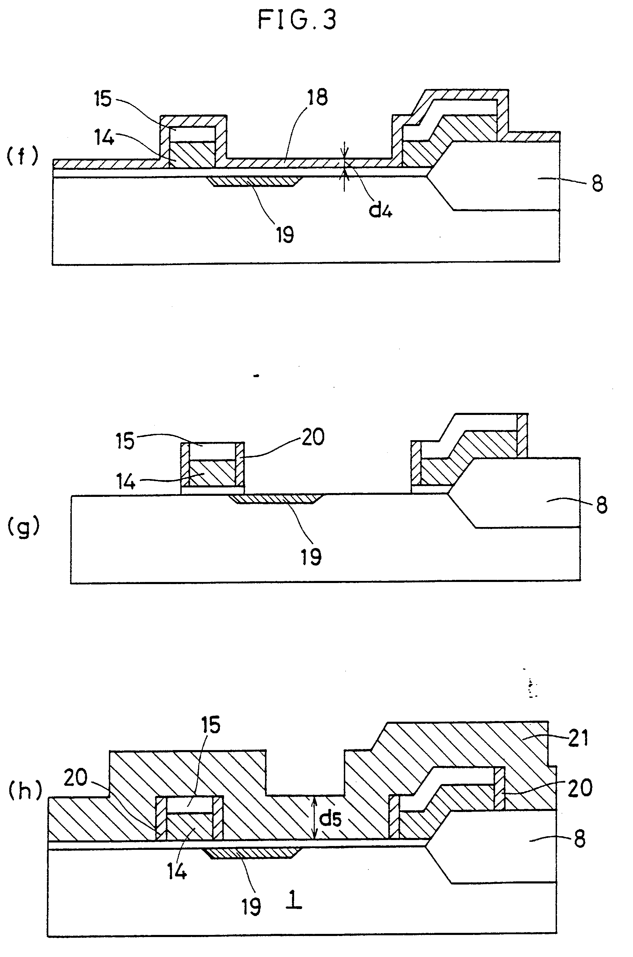

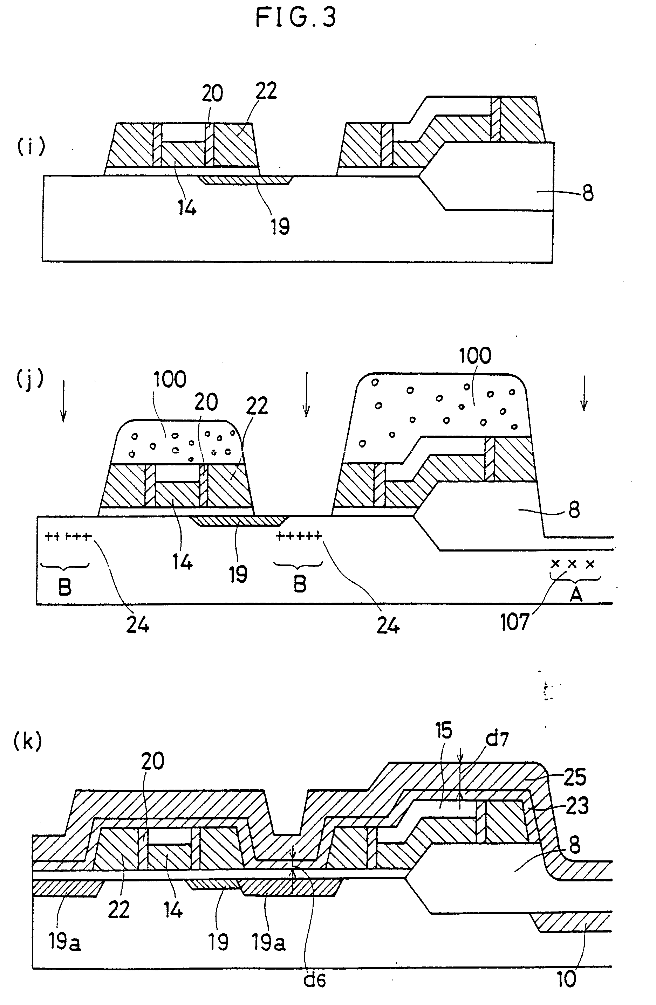

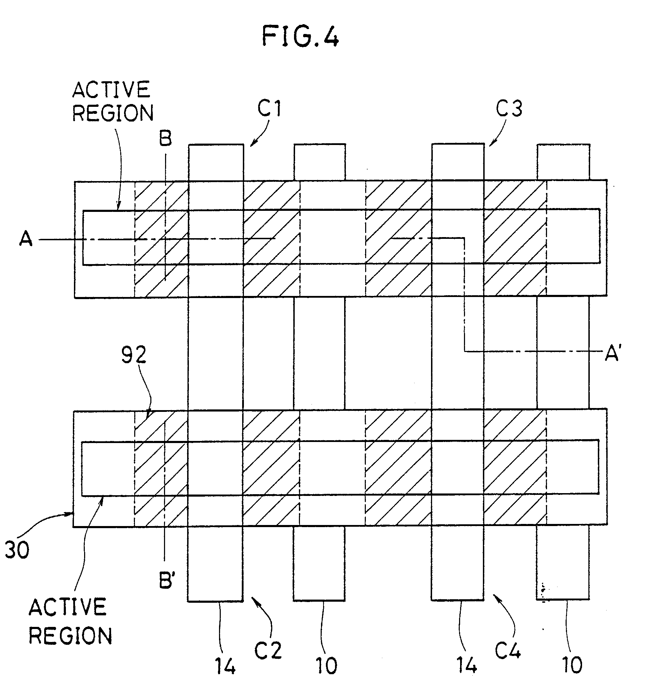

Also, in the present invention, as shown in Fig. 4, a buried diffusion layer 10 just below a field oxidation film 8 is employed for connecting source and drain diffusion layers 19, 19a (see Fig. 2(n)) in adjacent memory cells C1 and C2 and adjacent memory cells C3 and C4, and therefore, a Si substrate 1 in the buried diffusion layer 10 can be prevented from being dug when the CG 30 and the FG 92 are formed by etching. The formation of the buried layer 10 may be performed in either way as follows: ( I ) simultaneous with forming a field oxidation film after forming an ion implantation layer in a field region, or ( II ) after forming an ion implantation layer just below a region which is left after the field oxidation film is partially etched away. In the present invention, the buried diffusion layer 10 for connecting the drain diffusion layers 19a (the source diffusion layer 19 is directly connected to the drain diffusion layer 19a) in adjacent memory cells is formed just under the field oxidation film 8 so as not to be affected by the etching in forming the CG 30 and the FG 92 (seen Figs. 2(k) and 2(1)), or the field oxidation film 8 is left so as not to be affected by such etching in order to form the buried diffusion layer 10 (see Figs. 3(j) and 3(k)).

Thus, a reduction of the size of the memory cells enables a reduction of the size of the chip, and the yield of chips can be enhanced. This makes this invention useful in the art.

The present invention will now be described in detail in conjunction with the preferred embodiments shown in the accompanying drawings. However, it is not intended that the present invention be limited to the precise form of the description.

A flash memory cell where hot electrons are injected from a side of its source is, as shown in Figs. 2(n) and 4, mainly composed of the FG 92, the CG 30 and AG 14.

The FG 92 is formed by etching away a needless portion of the polysilicon side wall spacer 22 which is provided on the side wall of the AG 14 with a small piece SiO₂ piece (small piece of a first insulating film) 20 interposed between them, and on the Si substrate 1 having the field oxidation film 8 and the gate oxidation film (gate insulating film) 9, the source diffusion layer 19, the drain diffusion layer 19a directly connected to the source diffusion layer 19, the buried diffusion layer 10 just below the field oxidation film 8 and a gate oxidation film 9 are disposed, while the CG 30 is provided at least above the FG 92 through an ONO film of SiO₂-Sin-SiO₂ (a second insulating film) 23.

As shown in Fig. 4, pairs of the above-mentioned diffusion layers (19 and 19a) in the adjacent cells C1 and C2 are connected to each other by the buried diffusion layer 10. Also pairs of the above-mentioned diffusion layers (19, 19a) in the adjacent cells C3 and C4 are connected to each other by the buried diffusion layer 10.

As shown in Fig. 2(n), on the AG 14, a SiO₂ film 15 is provided. Over the CG 30, a BPSG film 29 is provided with a NSG film 28 interposed between them.

Now, a first manufacturing method according to the present invention will be described with reference to Figs. 2(a) to 2(n).

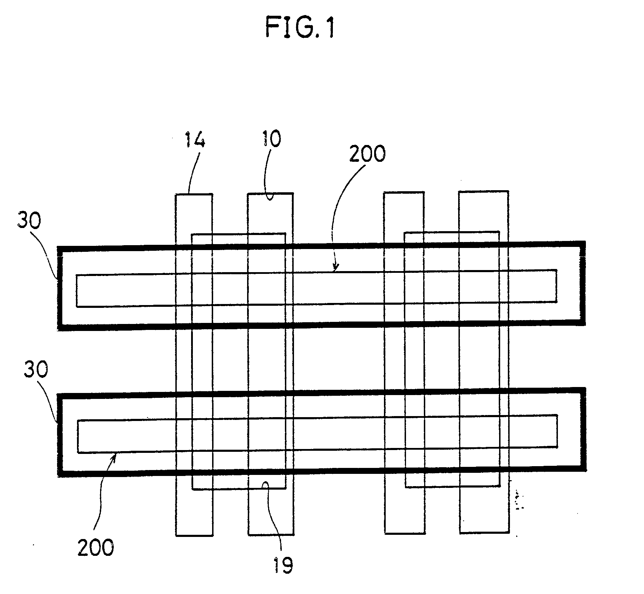

First, as shown in Fig. 2(a), a SiO₂ film 2 of 400 Å thickness is formed on the Si substrate 1 by a thermal oxidation method; thereafter, a SiN layer 3 of 1200 Å thickness and a resist layer are deposited on it, and a resist pattern 4 is formed to make a hole in the field region. The resist pattern 4 (corresponding to a portion other than the layout pattern 200 in Fig. 1) corresponds to a a portion other than active regions in the layout pattern in Fig. 1.

Then, the SiN layer 3 is etched away using a mask of the resist pattern 4, and a SiN film 5 is exposed.

After the resist pattern 4 is removed, a resist pattern 6 (corresponding to the layout pattern in Fig. 1) for an ion implantation is further formed over the Sin film 5 and the SiO₂ film 2 (Fig. 2(b)). Then, in the memory cells C1 and C2 (see Fig. 4), arsenic (As) ions are implanted in a region A shown in Fig. 2(b) to form an ion implantation layer 7 (Fig. 2(b)) for forming the buried diffusion layer 10 which is to connect the pairs of the source and drain diffusion layers (19, 19a) in the cells C1 and C2. An acceleration energy is 40 Kev, and an amount of the implanted ions is 1 x 10¹⁶ cm⁻².

At this time, as can be seen from the layout pattern 10 in Fig. 1, the resist pattern 6 has an opening 6a on the SiN film 5; however, no As ions are implanted into any region of the Si substrate 1 where the SiN film 5 and the SiO₂ film 2 lie.

Then, after the resist pattern 6 is removed, a SiO₂ field oxidation film 8 having a thickness d₁ of 5000 Å is formed to isolate devices by a selective oxidation method.

At this time, the ion implantation layer 7 is activated by the above-mentioned thermal treatment in forming the field oxidation film 8 and converted into the buried diffusion layer 10 just below the field oxidation film 8.

After that, removing the SiN film 5 and the SiO₂ film 2, a gate oxidation film (gate insulating film) 9 is formed (see Fig. 2(c)).

Then, on the overall surface of the Si substrate 1 including the field oxidation film 8 and the gate oxidation film 9, a polysilicon layer (first polysilicon layer) 11 having a thickness d₂ of 2000 Å, a SiO₂ film (NSG film) 12 having a thickness d₃ of 2000 Å are deposited one after another. Furthermore, a resist layer is formed on it, and a resist pattern 13 (corresponding to the layout pattern in Fig. 1) is formed to form the AG 14 (see Fig. 2(d)).

Next, using a mask of the resist pattern 13, the SiO₂ film 12 and the polysilicon layer 11 are etched to form the AG 14 having the SiO₂ film 15 on its upper surface.

Then, a resist pattern 16 (corresponding to a layout pattern 19 in Fig. 1) for an ion implantation is formed for forming a source region in the Si substrate, and ions of As are implanted to form an N⁺ ion implantation layer 17 (see Fig. 2(e)). At this time, the resist pattern 16 has an opening 16a in which a part of the AG 14 exists. An acceleration energy is 80 Kev while an amount of the implanted ions is 1 x 10¹⁶ cm⁻² .

After the resist pattern 16 is removed, a SiO₂ (NSG film) layer 18 having a thickness d₄ of 500 Å is formed over the entire surface of the Si substrate 1 including the AG 14 (see Fig. 2(f)).

Then, the SiO₂ layer 18 is etched back by reactive ion etching (RIE). Consequently, the small SiO₂ piece (small piece of the first insulating film) 20 is formed on the side wall of the AG 14 (see Fig. 2(g)). Instead of the small SiO₂ piece 20 as the first insulating film, an ONO film may be used which can be obtained by oxidizing the side wall of the AG 14 after the removal of the resist pattern 16, depositing a SiN layer, and then further oxidizing the SiN layer. Instead, a SiN layer alone may be used as the first insulating film.

Next, a polysilicon layer (second polysilicon layer) having a thickness d₅ of 4000 Å is deposited over the entire surface of the Si substrate including the AG 14 with the small SiO₂ piece 20 (see Fig. 2(h)), and succeedingly, the polysilicon layer 21 is etched back by means of RIE to form the polysilicon side wall spacer 22 contiguous to the small SiO₂ piece 20 on the side wall of the AG 14 (see Fig. 2(i)).

Then, a SiN layer is formed over the entire surface of the Si substrate including the AG 14 where the small SiO₂ piece 20 and the side wall spacer 22 are provided after the oxidation of the side wall spacer 22, and the ONO layer 23 into which a surface of the SiN layer is converted by oxidation is formed having a thickness d₆ of 200 Å over the entire surface of the Si substrate so as to serve as the second insulating film (seen Fig. 2(j)).

At this time, instead of the ONO layer 23, a SiN layer alone may be used as the second insulating film.

Then, with a mask of the AG 14 and the side wall spacer 22, As ions are implanted through the ONO layer 23 into the entire surface of the Si substrate including the AG 14 to form an ion implantation layer 24 in a region B. At this time, an acceleration energy is 80 Kev while an amount of the implanted ions is 1 x 10¹⁵cm⁻². Because of a succeeding thermal treatment, the ion implantation layer 24 serves as the drain diffusion layer 19a, which is directly connected to the source diffusion layer 19.

After that, a polysilicon layer having a thickness d₇ of 2000 Å (third polysilicon layer) 25 is deposited over the entire surface of the ONO layer 23 (see Fig. 2(k)).

Then, on the polysilicon layer 25, a resist pattern (corresponding to a layout pattern 30 in Fig. 1) 26 for forming the CG is formed (see Figs. 2(k) and 5(a)).

Next, using a mask of the resist pattern 26, the CG 30 is formed by etching the polysilicon layer 25 (see Fig. 2(l)). Simultaneously, the side wall spacer 22 which lies on a field oxidation film region (see symbol C in Fig. 2 (k))is removed by etching with a mask of the resist pattern 26 and then the FG 92 is formed (see Figs. 2(1) and 5(b)). Fig. 2(m) shows a preparation where the resist pattern 26 in Fig. 2(l) is removed. The CG 30 does not necessarily have to formed on the AG 14; it may formed at least on the FG 92.

Figs. 2(m) and 2(n) are sectional views taken along the line A - A' of Fig. 4 while Figs. 5(a) and 5(b) are sectional views taken along the line B - B' of Fig. 4, and Fig. 5(a) corresponds to Fig. 2(k) while Fig. 5(b) corresponds to Fig. 2(l).

In this way, in the present invention, a needless portion of the side wall spacer 22 on the side wall of the AG 14 is etched away with the mask of the resist pattern 26 employed for forming the CG by etching, and the FG 92 is simultaneously formed, so that they can all be formed at the same time with a single mask.

Last, a NSG film 28 having a thickness d₈ of 1500 Å and serving as a layer insulating film is deposited over the entire surface, and a BPSG film 29 having a thickness d₉ of 8000 Å is deposited on the NSG film 28 (see Fig. 2(n)). At this time, a BPSG film may be used as a layer insulating film instead of the NSG film 28.

In this way, the intended memory cell can be fabricated.

The operation of the resultant memory cells will be explained below.

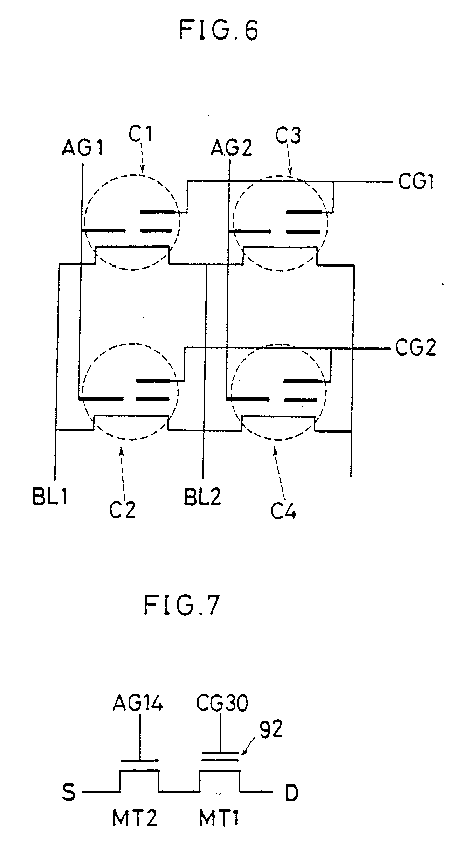

Referring to Figs. 6 and 7, under the condition that an MT1 transistor is excessively reversed (high voltage is applied to the CG 30), voltage near the threshold voltage Vₜₕ is applied to the AG 14, and as a result, an injection of hot electrons from the source side to the FG 92 enables writing.

**TABLE 1**

| | BL1 | BL2 | CG1 | AG1 |
|---|---|---|---|---|
| WRITE | GND | 5V | 12V | 2V |
| ERASE | GND | 5V | - 11V | GND |
| READ | GND | 3V | 5V | 5V |

Thus, in this embodiment, the FG 92 can be formed by removing the needless portion of the side wall spacer on the side wall of the AG 14 with the same mask of the resist pattern 26 which is used in forming the CG 30 by etching, so that the resultant cell can be reduced in area. Moreover, since a buried diffusion layer as bit line is formed just below a field oxidation film, the Si substrate 1 in the buried diffusion layer can be prevented from being dug because of the etching of the CG.

Then, with reference to Figs. 3(a) to 3(k), a second manufacturing method according to the present invention will be described.

First, as shown in Fig. 3(a), a SiO₂ film 2 of 400 Å thickness is formed on a Si substrate 1 by thermal oxidation. After that, a SiN layer 3 of 1200 Å thickness and a resist layer are deposited on it, and a resist pattern 4 is formed to make a hole in a field region to form a field oxidation film.

Then, the SiN layer 3 is etched away using a mask of the resist pattern 4 to expose the SiN film 5 (see Fig. 3(b)).

At this time, the SiO₂ film 2 is exposed in the field region.

After the resist pattern 4 is removed, the SiO₂ film 2 is removed, and then, a field oxidation film of SiO₂ having a thickness of 5000 Å is formed by a selective oxidation method. After that, the SiN film 5 and the SiO₂ film 2 are removed, and a gate oxidation film (gate insulating film) 9 of SiO₂ is formed (see Fig. 3(c)).

Over the whole surface of the Si substrate 1 including the field oxidation film 8 and the gate oxidation film 9, a polysilicon layer (a first polysilicon layer) 11 having a thickness d₂ of 2000 Å, a SiO₂ film (NSG film) 12 having a thickness d₃ of 2000 Å are deposited one after another. Furthermore, a resist layer is deposited on it, and a resist pattern 13 (corresponding to the layout pattern 14 in Fig. 1) is formed to form the AG 14 (see Fig. 3(d)).

Next, using a mask of the resist pattern 13, the SiO₂ film 12 and the polysilicon layer 11 are etched to form the AG 14 having a SiO₂ film 15 on its upper surface.

Then, a resist pattern 16 (corresponding to a layout pattern 19 in Fig. 1) for an ion implantation is formed for forming a source diffusion layer region in the Si substrate 1 including the AG 14, and ions of As are implanted to form an N⁺ ion implantation layer 17 (see Fig. 3(e)). At this time, the resist pattern 16 has an opening 16a in which a part of the AG 14 exists. An acceleration energy is 80 Kev while an amount of the implanted ions is 1 x 10¹⁵cm⁻². The resultant N⁺ ion implantation layer is later activated by a thermal treatment and converted into a source diffusion layer 19 (see Fig. 3(f)).

After the resist pattern 16 is removed, a SiO₂ (NSG) layer (a first insulating film) 18 having a thickness d₄ of 500 A is formed over the entire surface of the Si substrate 1 including the AG 14 (see Fig. 3(f)). At this time, instead of the SiO₂ layer 18 serving as the first insulating film, an ONO film may be used which can be obtained by oxidizing the side wall of the AG 14 after the removal of the resist pattern 16, depositing a SiN layer, and further oxidizing the SiN layer. Instead, a SiN layer alone may be used as the first insulating film.

Then, the SiO₂ layer 18 is etched back by reactive ion etching (RIE). Consequently, a small SiO₂ piece (small piece of the first insulating film) 20 is formed on the side wall of the AG 14 (see Fig. 3(g)).

Next, a polysilicon layer (second polysilicon layer) 21 having a thickness d₅ of 4000 Å is deposited over the entire surface of the Si substrate including the AG 14 with the small SiO₂ piece 20 (see Fig. 3(h)), and succeedingly, the polysilicon layer 21 is etched back by means of RIE to form a polysilicon side wall spacer 22 contiguous to the small SiO₂ piece 20 on the side wall of the AG 14 (see Fig. 3(i)).

Then, as shown in Fig. 3(j), a resist pattern 100 is formed so as to cover the AG 14 where the small SiO₂ piece 20 and the polysilicon side wall spacer 22 are provided on its side wall, and with a mask of the resist pattern 100, the field oxidation film 8 originally having the 5000 Å thickness is etched by about 4500 Å.

After that, with a mask of the resist pattern 100, arsenic (As) ions are implanted into the whole surface of the Si substrate 1 to form an ion implantation layer in a region B The ion implantation layer 24 is activated by a thermal treatment performed later and converted into a drain diffusion layer 19a, which is directly connected to a source diffusion layer 19. At the same time, in a region A, an ion implantation layer 107 is formed. The ion implantation layer 107 is activated by a thermal treatment performed later and converted into a buried diffusion layer 10 serving as bit line for connecting pairs of the source and drain diffusion layers 19 and 19a in adjacent memory cells C1 and C2, and adjacent memory cells C3 and C4 (Fig. 4).

An acceleration energy in the ion implantation is 80 Kev while an amount of the implanted ions is 1 X 10¹⁵ cm⁻² (Fig. 3(j)).

Then, after the side wall spacer 22 is oxidized, a SiN layer is formed over the entire surface of the Si substrate including the AG 14 where the small SiO₂ piece 20 and the side wall spacer 22 are provided, and an ONO layer 23 into which a surface of the SiN layer is converted by oxidation is formed having a thickness d₆ of 200 Å so as to serve as a second insulating film (see Fig. 3(k)).

At this time, instead of the ONO layer 23, a SiN layer alone may be used as the second insulating film.

After that, a polysilicon layer (third polysilicon layer) 25 having a thickness d₇ of 2000 Å is deposited over the whole surface of the SiN layer 23 (see Fig. 3(k)).

At this time, the ion implantation layer 107 is activated by a thermal treatment for forming the ONO layer 23 and the polysilicon layer (third polysilicon layer) 25 and converted into the buried diffusion layer 10 just under the etched portion of the field oxidation film. Simultaneously, the ion implantation layer 24 is activated and converted into the drain diffusion layer 19 a.

Then, similar to Fig. 2(k), a resist pattern 26 (corresponding to the layout pattern 30 in Fig. 1) for forming the CG is formed on the polysilicon layer 25. The process steps thereafter are similar to those shown in Figs. 2(k) to 2(n).

Thus, in this embodiment, in addition to the above-mentioned effects in the previous embodiment, the buried diffusion layer 10 can be formed simultaneously with the drain diffusion layer 19a, and a simplification of the process can be implemented.

As has been described, according to the present invention, with a mask of a resist pattern which is used in forming a control gate by etching, a part of a side wall spacer on an auxiliary gate which lies on a field oxidation film is simultaneously etched (i.e., they are self-aligned with each other), and therefore, an additional mask for forming a floating gate is not needed. Thus, a margin required on a superimposition in masking becomes useless, and an area for a memory cell can be reduced. Such a reduction of the size of the memory cell leads to a reduction of the size of a chip, which, in turn, leads to an enhancement of a yield.

Since a buried diffusion layer just below a field oxidation film is used for connecting pairs of source and drain diffusion layers in adjacent memory cells, a Si substrate in the buried diffusion layer can be prevented from being dug in forming the control gate and the floating gate by etching. In this point, the embodiment of the present invention is useful in the art.

## Claims

1. A non-volatile memory device consisting of a plurality of memory cells arranged along columns and rows of the device, said memory device comprising:
a field oxide film (8) electrically isolating adjacent cells formed in a substrate (1);
a plurality of auxiliary gates (14) running along a column direction and being formed on the substrate and at least partially over the field oxide film from a first polysilicon layer;
a plurality of control gates (30) running along a row direction;
wherein each of said plurality of cells is formed at the intersection of any of the auxiliary gates with any of the control gates and further comprises:
a floating gate (92) provided on a sidewall of the auxiliary gate from a sidewall spacer and being formed from a second polysilicon layer;
a first insulation film (20) provided between the floating gate and the auxiliary gate; and
a second insulation film (23) provided between the control gate and at least the floating gate;
wherein the control gate extends at least over the floating gate, and edges of the control gate and the floating gate are aligned in the column direction.

2. A non-volatile memory device according to claim 1, wherein the substrate (1) comprises a buried diffusion layer (10) running along the column direction, serving as a bit line connecting memory cells (C1,C2;C3,C4) adjacent to each other in the column direction.

3. A non-volatile memory device according to claim 2, wherein the bit line (10) is formed beneath the field oxide film (8).

4. A non-volatile memory device according to any of claims 1 to 3, wherein the first insulation film (20) is a SiO₂ film, a SiN film, or a multi-stratum ONO film having a SiO₂-SiN-SiO₂ configuration.

5. A non-volatile memory device according to any of claims 1 to 4, wherein the second insulation film (23) is a SiN film or a multi-stratum ONO film having a SiO₂-SiN-SiO₂ configuration.

6. A method of forming a non-volatile memory device according to any of claims 1 to 5 consisting of a plurality of memory cells arranged along columns and rows of the device, the method comprising:
(a) forming a field oxide film (8) in a substrate (1) and a gate insulating film (9) on the whole surface of the substrate;
(b) forming an auxiliary gate (14) on the substrate from a first polysilicon layer (11), running along the column direction and at least partially over the field oxide film;
(c) implanting ions into a region (17) on the substrate at one side of the auxiliary gate;
(d) forming a first insulation film (20) covering sidewalls of the auxiliary gate,
(e) forming sidewall spacers (22) on two opposing sides of the auxiliary gate from a second polysilicon layer (21), running along the column direction;
(f) implanting ions into a region (24) on the substrate using the auxiliary gate and sidewall spacers as a mask;
(g) depositing a third polysilicon layer (25) over at least the sidewall spacers through the intermediary of a second insulating film (23); and
(h) forming a control gate (30) running along the row direction and a floating gate (92), by etching the third polysilicon layer and the sidewall spacers respectively, the control gate extending at least over the floating gate.

7. A method of forming a non-volatile memory device according to claim 6, further comprising implanting ions (7;107) into a region of the substrate (1) where the field oxide film (8) is formed.

8. A method of forming a non-volatile memory device according to claim 6 or claim 7, wherein the control gate (30) and the floating gate (92) are formed by etching using the same mask.

9. A method of forming a non-volatile memory device according to any of claims 6 to 8, wherein the first insulation film (20) is a film chosen from a group consisting of a SiO₂ film, a SiN film, and a multi-stratum ONO film having a SiO₂-SiN-SiO₂ configuration.

10. A method of forming a non-volatile memory device according to any of claims 6 to 9, wherein the second insulation film (23) is a film chosen from a group consisting of a SiN film and a multi-stratum ONO film having a SiO₂-SiN-SiO₂ configuration.

## Patentansprüche

1. Nichtflüchtiges Speicherbauteil mit einer Vielzahl von Speicherzellen, die entlang Spalten und Zeilen des Bauteils angeordnet sind, mit:
- einem Feldoxidfilm (8), der in einem Substrat (1) ausgebildete benachbarte Zellen elektrisch isoliert;
- einer Vielzahl von Hilfsgates (14), die entlang der Spaltenrichtung verlaufen und auf dem Substrat und zumindest teilweise auf dem Feldoxidfilm aus einer ersten Polysiliciumschicht ausgebildet sind;
- einer Vielzahl von Steuergates (30), die entlang der Zeilenrichtung verlaufen;
- wobei jede der Vielzahl von Zellen an der Schnittstelle eines der Hilfsgates mit einem der Steuergates ausgebildet ist;
und ferner mit:
- einem potentialungebundenen Gate (92), das an einer Seitenwand des Hilfsgates über einem Seitenwand-Abstandshalter vorhanden ist und aus einer zweiten Polysiliciumschicht besteht;
- einem ersten Isolierfilm (20), der zwischen dem potentialungebundenen Gate und dem Hilfsgate vorhanden ist; und
- einem zweiten Isolierfilm (23), der zwischen dem Steuergate und zumindest dem potentialungebundenen Gate vorhanden ist;
- wobei sich das Steuergate zumindest über das potentialungebundene Gate erstreckt und Kanten des Steuergates und des potentialungebundenen Gates in der Spaltenrichtung ausgerichtet sind.

2. Nichtflüchtiges Speicherbauteil nach Anspruch 1, bei dem das Substrat (1) eine vergrabene Diffusionsschicht (10) aufweist, die entlang der Spaltenrichtung verläuft und als Bitleitung dient, die Speicherzellen (C1, C2; C3, C4), die in der Spaltenrichtung benachbart zueinander liegen, verbindet.

3. Nichtflüchtiges Speicherbauteil nach Anspruch 2, bei dem die Bitleitung (10) unter dem Feldoxidfilm (8) ausgebildet ist.

4. Nichtflüchtiges Speicherbauteil nach einem der Ansprüche 1 bis 3, bei dem der erste Isolierfilm (20) ein SiO₂-Film, ein SiN-Film oder ein mehrlagiger ONO-Film mit SiO₂-SiN-SiO₂-Konfiguration ist.

5. Nichtflüchtiges Speicherbauteil nach einem der Ansprüche 1 bis 4, bei dem der zweite Isolierfilm (30) ein SiN-Film oder ein mehrlagiger ONO-Film mit SiO₂-SiN-SiO₂-Konfiguration ist.

6. Verfahren zum Herstellen eines nichtflüchtigen Speicherbauteils nach einem der Ansprüche 1 - 5 aus einer Vielzahl von Speicherzellen, die entlang Spalten und Zeilen des Bauteils angeordnet sind, wobei das Verfahren folgendes umfasst:
(a) Herstellen eines Feldoxidfilms (8) in einem Substrat (1) und eines Gateoxidfilms (9) auf der gesamten Oberfläche des Substrats;
(b) Herstellen eines Hilfsgates (14) auf dem Substrat aus einer ersten Polysiliciumschicht (11), das entlang der Spaltenrichtung und zumindest teilweise über dem Feldoxidfilm verläuft;
(c) Implantieren von Ionen in einen Bereich (17) auf dem Substrat an einer Seite des Hilfsgates;
(d) Herstellen eines ersten Isolierfilms (20), der Seitenwände des Hilfsgates bedeckt;
(e) Herstellen von Seitenwand-Abstandshaltern (22) an zwei entgegengesetzten Enden des Hilfsgates aus einer zweiten Polysiliciumschicht (21), die entlang der Spaltenrichtung verlaufen;
(f) Implantieren von Ionen in einen Bereich (24) auf dem Substrat unter Verwendung des Hilfsgates und der Seitenwand-Abstandshalter als Maske;
(g) Abscheiden einer dritten Polysiliciumschicht (25) zumindest auf den Seitenwand-Abstandshaltern vermittels eines zweiten Isolierfilms (23); und
(h) Ausbilden eines Steuergates (30), das entlang der Zeilenrichtung verläuft, und eines potentialungebundenen Gates (92) durch Ätzen der dritten Polysiliciumschicht bzw. der Seitenwand-Abstandshalter, wobei sich das Steuergate zumindest über das potentialungebundene Gate erstreckt.

7. Verfahren zum Herstellen eines nichtflüchtigen Speicherbauteils nach Anspruch 6, ferner umfassend das Implantieren von Ionen (7; 107) in einen Bereich des Substrats (1), in dem der Feldoxidfilm (8) ausgebildet ist.

8. Verfahren zum Herstellen eines nichtflüchtigen Speicherbauteils nach Anspruch 6 oder Anspruch 7, bei dem das Steuergate (30) und das potentialungebundene Gate (92) durch Ätzen unter Verwendung derselben Maske hergestellt werden.

9. Verfahren zum Herstellen eines nichtflüchtigen Speicherbauteils nach einem der Ansprüche 6 bis 8, bei dem der erste Isolierfilm (20) ein Film ist, der aus einer Gruppe ausgewählt ist, die aus einem SiO₂-Film, einem SiN-Film und einem mehrlagigen ONO-Film mit SiO₂-SiN-SiO₂-Konfiguration besteht.

10. Verfahren zum Herstellen eines nichtflüchtigen Speicherbauteils nach einem der Ansprüche 6 bis 9, bei dem der zweite Isolierfilm (23) ein Film ist, der aus einer Gruppe ausgewählt ist, die aus einem SiN-Film und einem mehrlagigen ONO-Film mit SiO₂-SiN-SiO₂-Konfiguration besteht.

## Revendications

1. Dispositif de mémoire rémanente composé d'une pluralité de cellules de mémoire disposées le long de colonnes et de lignes du dispositif, ledit dispositif de mémoire comprenant :
une couche d'oxyde épais (8) isolant électriquement des cellules voisines formées dans un substrat (1) ;
une pluralité de grilles auxiliaires (14) s'étendant dans une direction de colonnes et formées sur le substrat et au moins en partie au-dessus de la couche d'oxyde épais depuis une première couche de polysilicium ;
une pluralité de grilles de commande (30) s'étendant dans une direction de lignes ;
dans lequel chacune de ladite pluralité de cellules est formée à l'intersection de l'une quelconque des grilles auxiliaires avec l'une quelconque des grilles de commande et comprend en outre :
une grille flottante (92) disposée sur une paroi latérale de la grille auxiliaire depuis une pièce d'écartement de paroi latérale et formée depuis une deuxième couche de polysilicium ;
une première couche isolante (20) disposée entre la grille flottante et la grille auxiliaire ; et
une seconde couche isolante (23) disposée entre la grille de commande et au moins la grille flottante ;
dans lequel la grille de commande s'étend au moins au-dessus de la grille flottante, et dans lequel des bords de la grille de commande et de la grille flottante sont alignés dans la direction des colonnes.

2. Dispositif de mémoire rémanente selon la revendication 1, dans lequel le substrat (1) comprend une couche de diffusion enterrée (10) s'étendant dans la direction des colonnes, jouant le rôle de ligne de binaires connectant des cellules de mémoire (C1, C2 ; C3, C4) voisines les unes des autres dans la direction des colonnes.

3. Dispositif de mémoire rémanente selon la revendication 2, dans lequel la ligne de binaires (10) est formée au-dessous de la couche d'oxyde épais (8).

4. Dispositif de mémoire rémanente selon l'une quelconque des revendications 1 à 3, dans lequel la première couche isolante (20) est une couche de SiO₂, une couche de SiN ou une couche ONO multi-strates ayant une configuration SiO₂-SiN-SiO₂.

5. Dispositif de mémoire rémanente selon l'une quelconque des revendications 1 à 4, dans lequel la seconde couche isolante (23) est une couche de SiN ou une couche ONO multi-strates ayant une configuration SiO₂-SiN-SiO₂.

6. Procédé de formation d'un dispositif de mémoire rémanente selon l'une quelconque des revendications 1 à 5 composé d'une pluralité de cellules de mémoire disposées le long de colonnes et de lignes du dispositif, le procédé comprenant les étapes consistant à :
(a) former une couche d'oxyde épais (8) dans un substrat (1) et une couche d'isolation de grille (9) sur la surface totale du substrat ;
(b) former une grille auxiliaire (14) sur le substrat depuis une première couche de polysilicium (11), s'étendant dans la direction des colonnes et au moins en partie au-dessus de la couche d'oxyde épais ;
(c) implanter des ions dans une zone (17) sur le substrat sur un côté de la grille auxiliaire ;
(d) former une première couche isolante (20) couvrant des parois latérales de la grille auxiliaire ;
(e) former des pièces d'écartement de paroi latérale (22) sur deux côtés opposés de la grille auxiliaire depuis une deuxième couche de polysilicium (21), s'étendant dans la direction des colonnes ;
(f) implanter des ions dans une zone (24) sur le substrat en utilisant la grille auxiliaire et les pièces d'écartement de paroi latérale en tant que masque ;
(g) déposer une troisième couche de polysilicium (25) au moins au-dessus des pièces d'écartement de paroi latérale par l'intermédiaire d'une seconde couche isolante (23) ; et
(h) former une grille de commande (30) s'étendant dans la direction des lignes et une grille flottante (92), en attaquant respectivement la troisième couche de polysilicium et les pièces d'écartement de paroi latérale, la grille de commande s'étendant au moins au-dessus de la grille flottante.

7. Procédé de formation d'un dispositif de mémoire rémanente selon la revendication 6, comprenant en outre l'implantation d'ions (7 ; 107) dans une zone du substrat (1) où la couche d'oxyde épais (8) est formée.

8. Procédé de formation d'un dispositif de mémoire rémanente selon la revendication 6 ou la revendication 7, dans lequel la grille de commande (30) et la grille flottante (92) sont formées par une attaque utilisant le même masque.

9. Procédé de formation d'un dispositif de mémoire rémanente selon l'une quelconque des revendications 6 à 8, dans lequel la première couche isolante (20) est une couche choisie dans le groupe comprenant une couche de SiO₂, une couche de SiN et une couche ONO multi-strates ayant une configuration SiO₂-SiN-SiO₂,

10. Procédé de formation d'un dispositif de mémoire rémanente selon l'une quelconque des revendications 6 à 9, dans lequel la seconde couche isolante (23) est une couche choisie dans le groupe comprenant une couche de SiN et une couche ONO multi-strates ayant une configuration SiO₂-SiN-SiO₂.
